# EUROPEAN PATENT APPLICATION

(11) **EP 3 951 375 A1**
(43) Date of publication of application: **09.02.2022**
(21) Application number: 20778581.7
(22) Date of filing: 25.03.2020
(51) Int. Cl.: G01N 27/30, G01N 27/48

(54) **ELECTRODE AND ELECTROCHEMICAL MEASUREMENT SYSTEM**

(30) Priority: 28.03.2019 JP 2019064138; 27.09.2019 JP 2019177621; 17.03.2020 JP 2020046682
(71) Applicant: Nitto Denko Corporation, Ibaraki-shi Osaka 567-8680 (JP); NATIONAL INSTITUTE OF ADVANCED INDUSTRIAL SCIENCE AND TECHNOLOGY, Tokyo 100-8921 (JP)
(72) Inventor: YAMAGATA, Kazuto, Ibaraki-shi, Osaka 567-8680 (JP); HAISHI, Motoki, Ibaraki-shi, Osaka 567-8680 (JP); TAKEMOTO, Mitsunobu, Ibaraki-shi, Osaka 567-8680 (JP); OSUKA, Koya, Ibaraki-shi, Osaka 567-8680 (JP); KATO, Dai, Tsukuba-shi Ibaraki 305-8560 (JP); KAMATA, Tomoyuki, Tsukuba-shi Ibaraki 305-8560 (JP)
(74) Representative: Gill Jennings & Every LLP
(86) International application number: PCT/JP2020/013228
(87) International publication number: WO 2020/196587

(57) **Abstract**

A carbon electrode 1 includes a substrate 2, and a conductive carbon layer 3 disposed at an upper side of the substrate 2 and having an sp² bond and an sp³ bond. On an upper surface of the conductive carbon layer 3, the concentration ratio of oxygen to carbon is 0.07 or more. The ratio of a number of sp³ bonded carbon atoms to the sum of a number of sp² bonded carbon atoms and the number of sp³ bonded carbon atoms is 0.35 or more.

## Description

The present invention relates to an electrode and an electrochemical measurement system. In particular, the present invention relates to an electrode and an electrochemical measurement system including the electrode.

### TECHNICAL FIELD

There is a known carbon electrode including a domain of sp² bonded and sp³ bonded microcrystals as a high-sensitive electrode for an electrochemical measurement (for example, see Patent Document 1).

### BACKGROUND ART

Anodic stripping voltammetry (ASV) is also known as a technique to measure metal ions in low concentrations in an aqueous solution with high sensitivity. In ASV, the metal ions included in the aqueous solution are reduced and condensed (deposited) on the surface of an electrode, and the reduced and condensed metals are oxidized and dissolved, and the metal ions are measured based on the current value at the oxidation and dissolution (for example, see Patent Document 2).

### Citation List

### Patent Document

Patent Document 1: Japanese Unexamined Patent Publication No. 2006-90875
Patent Document 2: Japanese Unexamined Patent Publication No. 2011-85531

### SUMMARY OF THE INVENTION

### PROBLEM TO BE SOLVED BY THE INVENTION

Recently, there are needs for an electrode having higher sensitivity.

In particular, it has been considered to use the carbon electrode described in Patent Document 1 in the anodic stripping voltammetry described in Patent Document 2.

However, in such a case, the metal ions cannot sufficiently be reduced and condensed on the carbon electrode. Thus there is a disadvantage that the metal ions cannot be measured with high sensitivity. Or, even when a trace amount of metal ions are reduced and condensed on the electrode, the condensed metals cannot be oxidized and dissolved. Thus, there is still a disadvantage that the metal ions cannot be measured with high sensitivity.

Further, where conventionally known cyclic voltammetry (CV) is used, there is a disadvantage that, when the reduction potential required for detecting the analyte increases, the measurement sensitivity decreases.

The present invention provides an electrode and an electrochemical measurement system with excellent sensitivity.

### MEANS FOR SOLVING THE PROBLEM

The present invention [1] includes an electrode comprising: a substrate; and a conductive carbon layer disposed at one side in a thickness direction of the substrate and having an sp² bond and an sp³ bond, wherein a concentration ratio of oxygen to carbon is 0.07 or less on a one-side surface in a thickness direction of the conductive carbon layer.

The present invention [2] includes the electrode described in [1] above, wherein the conductive carbon layer has a thickness of 5 nm or more and 200 nm or less.

The present invention [3] includes the electrode described in [1] or [2] above, wherein the one-side surface in the thickness direction of the conductive carbon layer has a surface roughness Ra of 1.0 nm or less.

The present invention [4] includes the electrode described in any one of the above-described [1] to [3], being an electrode for an electrochemical measurement.

The present invention [5] includes the electrode described in [4] above, being a working electrode, wherein the electrochemical measurement is anodic stripping voltammetry.

The present invention [6] includes an electrochemical measurement system comprising the electrode described in [4] or [5] above.

### EFFECTS OF THE INVENTION

In the electrode and electrochemical measurement system of the present invention, on the one-side surface in the thickness direction of the conductive carbon layer, the concentration ratio of oxygen to carbon is 0.07 or less. Thus, the analyte can be measured with high sensitivity.

In particular, the above-described concentration is 0.07 or less. Thus, in anodic stripping voltammetry, the analyte can sufficiently be reduced and condensed on the one-side surface in the thickness direction of the electrode, and the analyte can surely be oxidized and dissolved. The current value is sufficiently generated when the analyte is oxidized and dissolved.

In cyclic voltammetry, the analyte can sufficiently be reduced at low potential, and thus the measurement sensitivity can be increased.

Further, the concentration ratio of oxygen to carbon is 0.07 or less. Thus, the peak current at the oxidation and dissolution can be increased in anodic stripping voltammetry, and thus the measurement sensitivity can be more increased.

### BRIEF DESCRIPTION OF THE DRAWINGS

[FIG. 1] FIG. 1 is a cross-sectional view of an embodiment of the electrode of the present invention.
[FIG. 2] FIG. 2 is a schematic view of an electrochemical system using the electrode of FIG. 1.
[FIG. 3] FIG. 3 is a view of a CV chart of Example 1.
[FIG. 4] FIG. 4 is a view of the spectrum obtained by measuring the one-side surface in the thickness direction of the electrode of Example 1 with X-ray photoelectron spectroscopy (a wide scan analysis).
[FIG. 5] FIG. 5 is a view of the spectrum obtained by measuring the one-side surface in the thickness direction of the electrode of Example 1 with X-ray photoelectron spectroscopy (a narrow scan analysis).

### DESCRIPTION OF THE EMBODIMENTS

### <Embodiment>

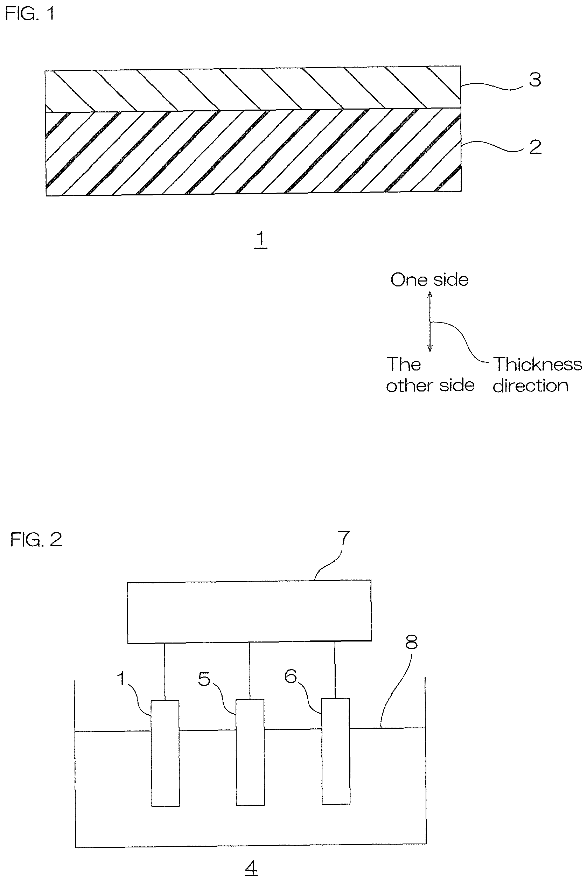

With reference to FIG. 1, a carbon electrode that is an embodiment of the electrode of the present invention will be described.

### 1. Carbon electrode

As illustrated in FIG. 1, a carbon electrode 1 has a film shape (including a sheet shape) with a predetermined thickness, and has a flat one-side surface and the other-side surface in the thickness direction.

Specifically, the carbon electrode 1 includes a substrate 2, and a conductive carbon layer 3 disposed at one side in the thickness direction of the substrate 2. In other words, the carbon electrode 1 includes the substrate 2, and the conductive carbon layer 3 at the one side in the thickness direction in order. Preferably, the carbon electrode 1 consists of the substrate 2 and the conductive carbon layer 3. Hereinafter, each of the layers will be described in detail.

### 2. Substrate

The substrate 2 forms the other-side surface in the thickness direction of the carbon electrode 1, and has a film shape. The substrate 2 supports the conductive carbon layer 3.

Examples of the substrate 2 include an inorganic substrate and an organic substrate.

Examples of the inorganic substrate include a silicon substrate and a glass substrate.

Examples of the organic substrate include polymer films. Examples of the material of the polymer film include polyester resins (such as polyethylene terephthalate, and polyethylene naphthalate), acetate resins, polyether sulfone resins, polycarbonate resins, polyamide resins, polyimide resins, polyolefin resins (such as polycycloolefin polymers), (meth)acrylic resins, polyvinyl chloride resins, polyvinylidene chloride resins, polystyrene resins, polyvinyl alcohol resins, polyarylate resins, and polyphenylenesulfide resins.

The substrate has a thickness of, for example, 2 µm or more, preferably 20 µm or more and, for example, 1000 µm or less, preferably 500 µm or less.

### 3. Conductive carbon layer

The conductive carbon layer 3 has conductivity and functions as an electrode. The conductive carbon layer 3 forms a one-side surface in the thickness direction of the carbon electrode 1.

The conductive carbon layer 3 is in contact with the whole of a one-side surface in the thickness direction of the substrate 2.

The conductive carbon layer 3 is formed of carbon having an sp² bond and an sp³ bond. In other words, the conductive carbon layer 3 is a layer having a graphite structure and a diamond structure. In this manner, the conductive carbon layer 3 has good conductivity and sufficiently improved sensitivity to the analyte. In particular, when the conductive carbon layer 3 is used in anodic stripping voltammetry, the analyte (specifically, metal ions) can sufficiently be reduced and condensed, and the reduced and condensed analyte can surely be oxidized and dissolved.

The ratio (sp³/sp³ + sp²) of the number of sp³ bonded atoms to the sum of the number of sp³ bonded atoms and the number of sp² bonded atoms is, for example, 0.1 or more, preferably 0.2 or more and, for example, 0.9 or less, preferably 0.5 or less.

The above-described ratio can be calculated based on the peak intensity of the sp² bond and the peak intensity of the sp³ bond in the spectrum obtained by measuring the one-side surface in the thickness direction of the conductive carbon layer 3 with X-ray photoelectron spectroscopy. The specific calculation will be described below in Examples.

On the one-side surface in the thickness direction of the conductive carbon layer 3, the concentration ratio of oxygen to carbon (O/C) is 0.07 or less.

Because the concentration ratio of oxygen (O/C) is 0.07 or less, the sensitivity of the carbon electrode 1 can sufficiently be improved. In particular, when the conductive carbon layer 3 is used as the working electrode for anodic stripping voltammetry, the analyte can sufficiently be reduced and condensed on the surface of the conductive carbon layer 3. Thus, the analyte can be measured with high sensitivity.

Further, because the concentration ratio of oxygen (O/C) is 0.07 or less, the peak current can sufficiently be increased when the analyte is oxidized and dissolved. Thus, measurement sensitivity can be more increased.

Meanwhile, the lower limit of the concentration ratio of oxygen (O/C) is not especially limited. The concentration ratio of oxygen (O/C) is, for example, more than 0.00, 0.01 or more, 0.02 or more, or 0.03 or more.

The above-described concentration ratio can be calculated based on the peak area of C1s and the peak area of O1s in the spectrum obtained by measuring the one-side surface in the thickness direction of the conductive carbon layer 3 with X-ray photoelectron spectroscopy. The specific calculation will be described below in Examples.

The one-side surface in the thickness direction of the conductive carbon layer 3 has a surface roughness Ra of, preferably, 1.0 nm or less and, for example, 0.05 nm or more. When the surface roughness Ra is the above-described upper limit or less, use of the carbon electrode 1 as the electrode for an electrochemical measurement can suppress noise in the current. Thus, the measurement can be carried out with higher sensitivity.

The surface roughness Ra can be measured by the observation of a 500 nm square of the one-side surface in the thickness direction of the conductive carbon layer 3 using an atom force microscope. The specific measurement will be described below in Examples.

The one-side surface in the thickness direction of the conductive carbon layer 3 has a surface resistance value of, for example, 1.0 × 10⁴Ω/□ or less, preferably 1.0 × 10³Q/□ or less. The surface resistance value can be measured with a four-point probes method in conformity with JIS K 7194.

The conductive carbon layer 3 has a thickness of, for example, 5 nm or more, more preferably 10 nm or more and, for example, 200 nm or less, more preferably 100 nm or less. When the thickness of the conductive carbon layer 3 is the above-described lower limit or more, the conductive carbon layer 3 has excellent film-forming properties and thus can develop stable electrode properties. On the other hand, when the thickness of the conductive carbon layer 3 is the above-described upper limit or less, the conductive carbon layer 3 can be thinned and has excellent flexibility and thus is given good handleability.

The thickness of the conductive carbon layer 3 can be calculated by the measurement of the X-ray reflectivity of the conductive carbon layer 3. The specific calculation will be described below in Examples.

The conductive carbon layer 3 can contain another additive agent (including another element) in addition to carbon and oxygen. The conductive carbon layer can consist of a plurality of layers each having a different structure, composition, and additive agent concentration. Alternatively, the conductive carbon layer 3 can have a structure in which, for example, the structure, composition, and additive agent concentration gradually change (in gradations).

The carbon electrode 1 has a thickness that is a total thickness of the substrate 2 and conductive carbon layer 3, for example, 2 µm or more, preferably 20 µm or more and, for example, 1000 µm or less, preferably 500 µm or less.

### 4. Method of fabricating the carbon electrode

A method of fabricating the carbon electrode 1 includes in order, for example, a first step of preparing the substrate 2, a second step of providing the substrate 2 with a carbon thin film, and a third step of fabricating the conductive carbon layer 3 by subjecting the carbon thin film to surface finishing.

In the first step, a known or commercially available substrate 2 is prepared. As necessary, a one-side surface in the thickness direction of the prepared substrate 2 can be subjected to a foundation process and/or known cleansing.

In the second step, the carbon thin film is provided on the one-side surface in the thickness direction of the substrate 2.

Preferably, a dry method is used to form the carbon thin film on the one-side surface in the thickness direction of the substrate 2.

Examples of the dry method include a PVD method (physical vapor deposition method) and a CVD method (chemical vapor deposition method). Preferably, a PVD method is used.

Examples of the PVD method include a sputtering technique, a vacuum deposition method, a laser deposition method, and an ion plating method (such as an arc deposition method). To reduce the hydrogen contained in the conductive carbon layer 3 and surely form the film of the conductive carbon layer 3, preferably, a sputtering technique is used.

Examples of the sputtering technique include an unbalanced magnetron sputtering technique (UMB sputtering technique), a high-power pulsed sputtering technique, an electron cyclotron resonance sputtering technique, an RF sputtering technique, a DC sputtering technique (DC magnetron sputtering technique), a DC pulsed sputtering technique, and an ion beam sputtering technique.

To easily form the film of the conductive carbon in a desired range of the ratio of sp³ bonds to sp² bonds, and to improve the film deposition rate and the adhesion to the substrate 2, more preferably, a UBM sputtering technique is used.

When a sputtering technique is used, carbon (preferably, a sintered carbon) can be used as the targeted material. To adjust the film quality or stabilize the process, the targeted material may contain a known additive agent.

Examples of the sputtering gas include inert gases such as Ar and Xe.

The sputtering technique is carried out under vacuum. Specifically, to suppress the reduction in the sputtering rate and stabilize the electrical discharge, the pressure at the sputtering is, for example, 1 Pa or less, preferably 0.7 Pa or less.

The film deposition temperature (the substrate temperature) is, for example, 200°C or less, preferably 120°C or less and, for example, -40°C or more, preferably 0°C or more.

Further, to form the conductive carbon layer 3 with a desired thickness, for example, the conditions for the targeted material or the sputtering can appropriately be set and the sputtering technique can be carried out several times.

In this manner, an intermediate including the substrate 2 and the carbon thin film in order in the thickness direction is obtained.

In the third step, the carbon thin film is subjected to surface finishing, thereby producing the conductive carbon layer 3.

Examples of the surface finishing include ion milling, an ion impact process (ion bombardment), and electrolytic polishing. To maintain the flatness of the conductive carbon layer 3, preferably, ion milling is used as the surface finishing of the carbon thin film.

Further, these can be used singly or in combination. Preferably, ion milling is singly used.

In ion milling, in the presence of the above-described inert gas (specifically, Ar), the carbon thin film is irradiated with ion beams, thereby grinding the surface of the carbon thin film. Ion milling can be carried out by a known ion milling device.

The ion milling carried out under vacuum. Specifically, for plasma stability, the pressure at the ion milling is, for example, 1 Pa or less, for example, 1×10⁻² Pa or more.

In this manner, the oxygen concentration on a one-side surface in the thickness direction of the carbon thin film is adjusted (decrease), thereby forming the conductive carbon layer 3. In this manner, the carbon electrode 1 including the substrate 2 and conductive carbon layer 3 in order toward the one side in the thickness direction.

5. An electrode for an electrochemical measurement and an electrochemical measurement system

The carbon electrode 1 can be used as various electrodes and, preferably, used as the electrode for an electrochemical measurement, specifically, as the working electrode (working pole) to carry out cyclic voltammetry (CV), or as the working electrode to carry out anodic stripping voltammetry (ASV).

When the carbon electrode 1 is used as an electrode, an insulating layer patterned into a desired shape can be provided on the one-side surface in the thickness direction of the carbon electrode 1 to adjust the exposed surface (electrode surface) of the conductive carbon layer 3. Alternatively, the carbon electrode 1 or the conductive carbon layer 3 can entirely be pattered into a desired shape. Examples of the insulating layer include the polymer film in the above description of the substrate 2.

Next, an electrochemical measurement system 4 that uses the carbon electrode 1 as the working electrode will be described in detail.

The electrochemical measurement system 4 includes the carbon electrode 1, a reference electrode, a potentiometer that measures the electromotive force between the electrodes, and an aqueous solution (electrolytic solution).

Specifically, as illustrated in FIG. 2, the electrochemical measurement system 4 includes the carbon electrode 1 as an example of the working electrode, a reference electrode 5, a counter electrode 6, a potentiostat 7 that controls the electrode potentials of the electrodes, an ammeter that measures the current flowing between the carbon electrode 1 and the counter electrode 6 (the ammeter is not illustrated because being incorporated in the potentiostat), and an aqueous solution 8 (see FIG. 2).

Examples of the reference electrode 5 include a silver/silver chloride electrode, a saturated calomel electrode, and a standard hydrogen electrode.

Examples of the counter electrode 6 include a platinum electrode, a gold electrode, and a nickel electrode.

Examples of the aqueous solution 8 include aqueous solutions including the analyte.

Examples of the analyte include metal ions and peroxides such as hydrogen peroxide. Examples of the metal ions include heavy metal ions such as iron ion, lead ion, gold ion, platinum ion, silver ion, copper ion, chromium ion, cadmium ion, mercury ion, zinc ion, arsenic ion, manganese ion, cobalt ion, nickel ion, molybdenum ion, tungsten ion, tin ion, bismuth ion, uranium ion, and plutonium ion. Preferably, peroxide, more preferably, hydrogen peroxide is used.

The aqueous solution 8 is allowed to have a low concentration of the analyte of, for example, 10,000 µg/mL or less, 1,000 µg/mL or less, 100 µg/mL or less, 10 µg/mL or less, or 1 µg/mL or less and, for example, 100 ng/mL or more, or 500 ng/mL or more.

Further, in the carbon electrode 1 and the electrochemical measurement system 4, the conductive carbon layer 3 has sp² bonds and sp³ bonds, and the concentration ratio of oxygen to carbon is 0.07 or less on the one-side surface in the thickness direction of the conductive carbon layer 3.

Thus, where an electrochemical measurement, specifically, cyclic voltammetry is carried out with the electrochemical measurement system 4, a potential-current line on the horizontal axis representing the potential and the vertical axis representing the current can be obtained when the potential applied to the carbon electrode 1 (the working electrode) is swept (scanned) from 0V to the negative potential direction.

The line has a curve 5 protruding downward (toward the negative side, or the reduction-current side) in the vertical direction. When a line segment 7 passing through two shoulders 9 on the curve is formed to measure the current difference between the line segment 7 and the curve 5, the point having the maximum current difference is obtained as a reduction peak potential V1.

In the embodiment, the concentration ratio of oxygen to carbon is 0.07 or less, namely, low. Thus, as shown in Table 1, the reduction peak potential V1 notably decreases. Accordingly, the carbon electrode 1 allows the reduction of hydrogen peroxide at lower potential. Thus, the sensitivity can be improved.

In addition, the concentration ratio of oxygen to carbon is 0.07 or less, namely, low. Thus, the peak current value at the oxidation of the analyte can be increased. Hence, the sensitivity to the analyte can even more be increased.

Accordingly, the carbon electrode 1 in the electrochemical measurement system 4, specifically, the carbon electrode 1 in cyclic voltammetry has excellent sensitivity.

Next, a specific example in which the above-described carbon electrode 1 is used as the working electrode in anodic stripping voltammetry (ASV) will be described.

In ASV, the description of the same structure as described above will be omitted.

The electrochemical measurement system 4 used in the anodic stripping voltammetry includes the carbon electrode 1, the carbon electrode 1, a reference electrode, a potentiometer that measures the electro motiveforce between the electrodes, and an aqueous solution (electrolytic solution).

Examples of the analyte included in the aqueous solution 8 include the above-described metal ions, preferably, the heavy metal ions.

In the above-described electrochemical measurement system 4, when the anodic stripping voltammetry is carried out, the analyte can sufficiently be reduced and condensed the one-side surface in the thickness direction of the conductive carbon layer 3.

Further, the concentration ratio of oxygen to carbon is 0.07 or less. Thus, the peak current value at the oxidation and dissolution can be increased. Accordingly, the background noise does not easily give effect on the measurement and the analyte is easily be detected. Thus, the resolution for detecting the analyte can be increased.

On the other hand, when the concentration ratio of oxygen to carbon is 0.08 or more, the peak current value at the oxidation and dissolution cannot be increased. Accordingly, the background noise easily gives effect on the measurement and the analyte is difficult to be detected. Thus, the resolution for detecting the analyte cannot be increased.

Thus, in the electrochemical measurement system 4 used in the anodic stripping voltammetry of the embodiment, a sufficient current value is obtained when the analyte is oxidized and dissolved. As a result, the analyte can be measured with high sensitivity.

### 6. Variations

The carbon electrode 1 illustrated in FIG. 1 consists of the substrate 2 and the conductive carbon layer 3. However, for example, although not illustrated, one or 2 or more function layer(s) can be included between the substrate 2 and the conductive carbon layer 3 or at a lower side of the substrate 2. Examples of the function layer include a gas barrier layer, a conductive layer, an adhesive layer, and a surface smoothing layer.

### Example

The present invention will be more specifically described below with reference to Examples and Comparison Example. The present invention is not limited to any of the Examples and Comparison Example. The specific numeral values used in the description below, such as mixing ratios (contents), physical property values, and parameters can be replaced with the corresponding mixing ratios (contents), physical property values, and parameters in the above-described "DESCRIPTION OF EMBODIMENTS", including the upper limit values (numeral values defined with "or less", and "less than") or the lower limit values (numeral values defined with "or more", and "more than").

### (Example 1)

A substrate 2 made from a silicon substrate with a thickness of 300 µm was prepared (implementation of the first step).

Next, using a UBM sputtering technique, a carbon thin film with a thickness of 35 nm was formed on a one-side surface in a thickness direction of the substrate 2. The conditions of the sputtering technique will be described below.
Targeted material: sintered carbon
Argon gas pressure: 0.6 Pa
Target power: 400 W
Substrate temperature: 120°C or less
DC bias (between the silicon substrate and the sintered carbon target): 75 V
In this manner, an intermediate (laminate) including the substrate 2 and the carbon thin film was produced.

Thereafter, the carbon thin film of the intermediate was subjected to ion milling under the following conditions.

### <Ion milling >

Ion milling system: 3-IBE (manufactured by Hakuto Co., Ltd.)
Argon gas pressure: 4×10⁻² Pa
In this matter, a conductive carbon layer 3 was produced from the carbon thin film (implementation of the third step).

In this manner, the carbon electrode 1 including the substrate 2 and conductive carbon layer 3 was produced.

### (Example 2)

As shown in Table 1, except that the thickness of the conductive carbon layer 3 and the surface roughness Ra of the one-side surface in a thickness direction were changed, a carbon electrode 1 was produced in the same manner as in Example 1.

### (Example 3)

Except that the conductive carbon layer 3 was irradiated with ultraviolet light (illumination intensity 20 mW/cm², 30 seconds) after the ion milling, a carbon electrode 1 was produced in the same manner as in Example 1.

To carry out an experimental example at a concentration ratio of oxygen (O/C) different from Example 1, the conductive carbon layer 3 after the ion milling was irradiated with ultraviolet light in Example 3.

### (Comparative Example 1)

Except that the conductive carbon layer 3 was irradiated with ultraviolet light (illumination intensity 20 mW/cm², 300 seconds) after the ion milling, a carbon electrode 1 was produced in the same manner as in Example 1.

To carry out an experimental example at a concentration ratio of oxygen (O/C) different from Example 1, the conductive carbon layer 3 after the ion milling was irradiated with ultraviolet light in Comparative Example 1.

### (Comparative Example 2)

A carbon electrode 1 was produced in the same manner as in Example 1 except that the one-side surface in the thickness direction of the carbon thin film was oxidized by carrying out an applying potential cycle between 0 V and 2.3 V 10 times, instead of the ion milling, to produce the conductive carbon layer 3.

To carry out a comparative experimental example at a concentration ratio of oxygen (O/C) different from Example 1, the voltage was applied to the carbon thin film (as an electrochemical process) in Comparative Example 2.

### (Comparative Example 3)

A carbon electrode 1 was produced in the same manner as in Example 1 except that the one-side surface in the thickness direction of the carbon thin film was oxidized by carrying out an applying potential between 0 V and 2.3 V 12 times, instead of the ion milling, to produce the conductive carbon layer 3.

To carry out a comparative experimental example at a concentration ratio of oxygen (O/C) different from Example 1, the voltage was applied to the carbon thin film (as an electrochemical process) in Comparative Example 3.

### <Evaluations>

### (Measurement of the concentration ratio of oxygen) (Measurement of sp³ and sp²)

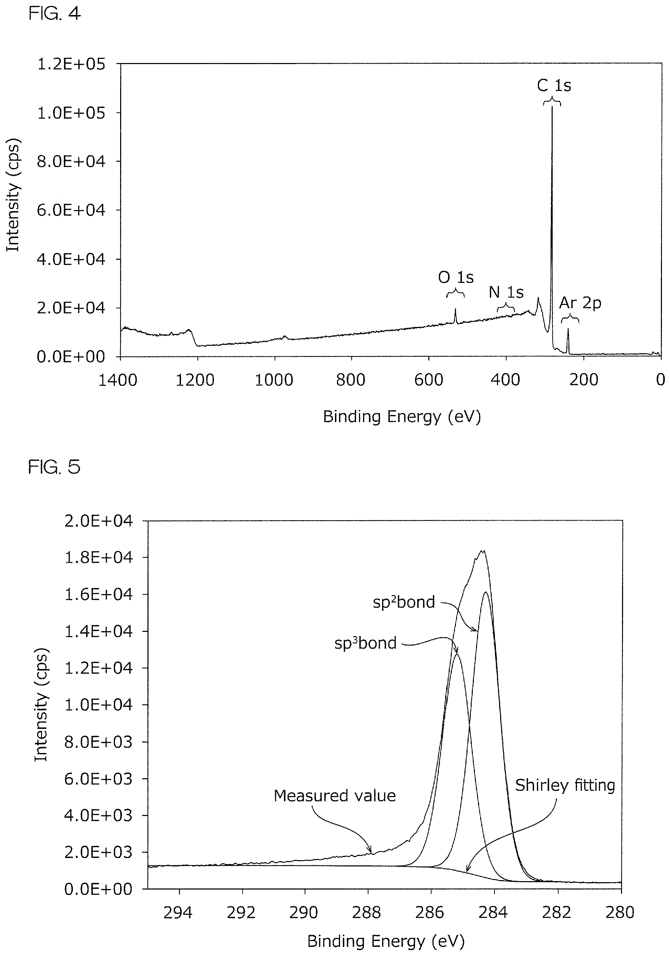

The one-side surface in the thickness direction of the conductive carbon layer 3 of each Example and Comparison Example was subjected to X-ray photoelectron spectroscopy under the following <Measurement conditions>. From the spectrum graph obtained in this manner (see FIG. 4 and FIG. 5), each peak area was obtained, thereby calculating the concentration ratio and the ratio of the number of carbon atoms. The concentration ratio (O/C) of oxygen to carbon is shows in Table 1. The ratio (sp³/sp³ + sp²) of the number of sp³ bonded carbon atoms to the sum of the number of sp² bonded carbon atoms and the number of sp³ bonded carbon atoms was approximately 0.4 in each Example and Comparison Example.

### <Measurement conditions>

Measurement device: X-Ray Photoelectron Spectrometer (XPS) (manufactured by Shimadzu Corporation, the trade name of "AXIS Nova")
X-ray source: AlKα (1486.6 eV) with a diameter 500 mm Rowland monochromator, 15 kV, 10 mA
Photoelectron spectrometer: orbital radius 165 mm, a combination of a static double hemispherical analyzer/a spherical mirror analyzer
Detector: a delay line detector (DLD) system
Energy resolution: Ag3d5/2 photoelectron peak is the full width at half maximum of 0.48 eV or less.
Charge neutralization: homogeneous low-energy electron irradiation

### (Measurement of the thickness)

Using X-ray reflectometry as the measurement principle, and a powder X ray diffractometer (manufactured by Rigaku Corporation, "RINT-2200"), under the following measurement conditions, the X-ray reflectivity was measured and the obtained measurement data was analyzed by an analytics software (manufactured by Rigaku Corporation, "GXRR3"), thereby calculating the thickness of the conductive carbon layer 3 of each Example and Comparison Example.

For the analysis, under the following <analysis conditions>, a two-layered model of the substrate 2 and conductive carbon layers 3 was used, and the targeted thickness of the conductive carbon layer 3, the surface roughness of 0.5 nm, and the density of 1.95 g/cm³ were input as initial values, and thereafter Least squares fitting with the measured values was carried out, thereby calculating the thickness of the conductive carbon layer 3. The results are shown in Table 1.

### <Measurement conditions>

Measurement device: a powder X-ray diffractometer (manufactured by Rigaku Corporation, "RINT-2200")
Light source: Cu-Kα rays (wavelength: 1,5418A), 40 kV, 40 mA
Optical system: a parallel beam optical system
Divergence slit: 0.05 mm
Receiving slit: 0.05 mm
Monochromatization-Paralellization: A multi-layered Goebel mirror was used.
Measurement mode: θ/2θ scan mode
Measurement range (2θ): 0.3-2.0°

### <Analysis conditions>

Analytics software: manufactured by Rigaku Corporation, "GXRR3"
Analysis technique: Least squares fitting
Analysis range (2θ):2θ = 0.3-2.0°

### (Measurement of the surface roughness)

The arithmetic meant surface roughness Ra of the one-side surface in the thickness direction of the conductive carbon layer of each Example and Comparison Example was measured in a range of 500 nm × 500 nm with an atom force microscope (Digital Instruments, Inc., the trade name of "Nanoscope IV"). The results are shown in Table 1.

### [Measurement Example 1]

### (Measurement of zinc by ASV)

An insulating tape having a hole with a diameter of 2 mm was adhered to the one-side surface in the thickness direction of the conductive carbon layer 3 of the carbon electrode 1 in each of Examples 1 to 3 and Comparative Examples 1 to 3, the exposed area of the conductive carbon layer 3 was set to 3.14mm². The carbon electrode 1, a reference electrode 5 (silver-silver chloride: Ag/AgCl), and a counter electrode 6 (platinum: Pt) were inserted into an ammonia buffer solution (pH 8.0). Further, the carbon electrode 1, the reference electrode 5, and the counter electrode 6 were connected to a potentiostat 7 (manufactured by CH Instruments, Inc., ALS 1240B).

Thereafter, a trace amount of zinc chloride was added so that the zinc ions concentration in the ammonia buffer solution became 100 ng/mL, and thereby preparing an aqueous solution containing a low concentration of zinc chloride.

Thereafter, ASV (anodic stripping voltammetry) was carried out.

Specifically, first, the reduction potential was set to -1.4 V, and the deposition time to 120 seconds. Then, a potential was applied to the carbon electrode 1. In this manner, the zinc ions in the aqueous solution containing a low concentration of zinc chloride were reduced and condensed (deposed) on the one-side surface in the thickness direction of the conductive carbon layer 3.

Subsequently, the frequency was set to 40 Hz, the potential increase to 2 mV, and the amplitude to 25 mV. Then, square-wave voltammetry was carried out, thereby oxidizing and dissolving the zinc onto the one-side surface of the conductive carbon layer 3.

As a result, in Examples 1 to 3, the increase in oxidation current was observed.

However, in Comparative Examples 1 to 3, the increase in oxidation current was not observed. In other words, it is presumed that the reduction and condensation of the zinc ions was inhibited or the oxidation and dissolution of the zinc was inhibited.

### [Measurement Example 2]

### (Peak current value in Zn oxidation)

The peak current value at the oxidation and dissolution of the zinc was obtained on the carbon electrode 1 in each of Example 1, and Example 3 to Comparative Example 3 as measured in Measurement Example 1. The results are summarized in Table 1. The above-described Measurement was carried out twice in total, and the average thereof was obtained as the peak current value was obtained.

In Examples 1 and 3, the concentration ratio of oxygen to carbon was 0.07 or less. Thus, the peak current value was 9.5 × 10⁻⁷ A or more, namely, high. Hence, the zinc ions were detected with excellent sensitivity.

Contrarily, in Comparative Examples 1 to 3, the concentration ratio of oxygen to carbon was 0.08 or more. Thus, the peak current value was 6.7 × 10⁻⁷ A or less, namely, low. Hence, the zinc ions were detected with insufficient sensitivity.

### [Measurement Example 3]

### (Measurement of hydrogen peroxide by CV)

An insulating tape having a hole with a diameter of 2 mm was adhered to the one-side surface in the thickness direction of the conductive carbon layer 3 the carbon electrode 1 in each of Examples 1 to 3 and Comparative Examples 1 to 3, the exposed area of the conductive carbon layer 3 was set to 3.14 mm². The carbon electrode 1, a reference electrode 5 (silver-silver chloride: Ag/AgCl), and a counter electrode 6 (platinum: Pt) were inserted into 50 mmol/L of a phosphate buffer solution (pH 7.0). Further, hydrogen peroxide was added to the above-described phosphate buffer solution so that the hydrogen peroxide concentration became 200 µmol/L (6.8 µg/1 mL). Furthermore, the carbon electrode 1, the reference electrode 5, and the counter electrode 6 were connected to a potentiostat 7 (manufactured by CH Instruments, Inc., ALS 1240B).

Thereafter, a trace amount of hydrogen peroxide was added so that the hydrogen peroxide concentration in the phosphate buffer solution became 7 ng/mL (0.2 mM), and thereby preparing an aqueous solution containing a low concentration of hydrogen peroxide.

Thereafter, CV (cyclic voltammetry) was carried out.

Specifically, the scan rate was set to 0.1 V/s, and the potential from 0 V to the negative direction were applied to the carbon electrode 1. In this manner, the hydrogen peroxide in the solution was reduced.

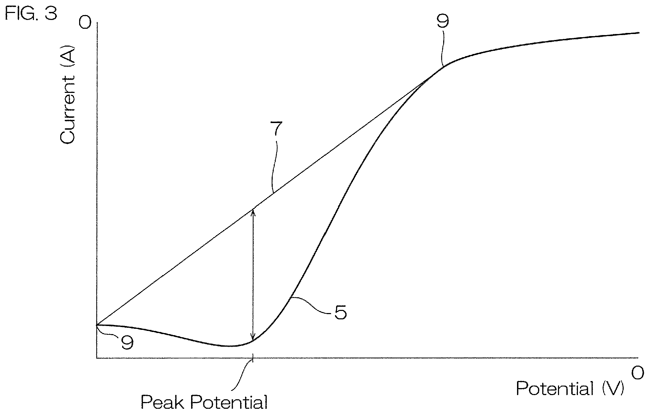

The CV chart of Example 1 is transcribed in FIG. 3.

The evaluation was made as follows.

Good: the reduction peak potential V1 was -1.0 V or more, and 0 V or less. Thus, it means that hydrogen peroxide can sufficiently be reduced at lower potential, in short, the sensitivity is good. Bad: the reduction peak potential V1 was less than -1.0V. In other words, it means that the reduction of hydrogen peroxide requires a higher reduction potenatial, and the sensitivity decreases.

### (Position of Comparative Example 1)

In Comparative Example 1, the concentration ratio of oxygen to carbon (O/C) was 0.08, or the concentration ratio of oxygen to carbon (O/C) was out of range of 0.07 or less. Thus, Comparative Example 1 is not included in the present invention. In Comparative Example 1, the detection of Z by the ASV of the present invention was "success" and, the detection of H₂O₂ by CV was "Good". However, the peak current at the Zn oxidation was notably lower than that of Example 3 in which the concentration ratio of oxygen to carbon (O/C) was 0.07. Hence, the measurement sensitivity of Comparative Example 1 was remarkably lower than that of Example 3.

**Table 1**

| Examples / Comparative Examples | Conductive carbon layer | | | Evaluations | | | | |
|---|---|---|---|---|---|---|---|---|
| | O/C ratio | Thickness (nm) | Surface roughness (nm) | Detection of Zn by ASV | Peak cur (×10 | rent value ⁻⁷A) | Detection of H2O2 by CV | |
| | | | | | | | | (V) |
| Example 1 | 0.03 | 35 | 0.9 | Success | Good | 9.5 | Good | -0.7 |
| Example 2 | 0.03 | 5 | 0.8 | Success | - | | Good | -0.7 |
| Example 3 | 0.07 | 35 | 0.9 | Success | Good | 13.4 | Good | -0.8 |
| Comparative Example 1 | 0.08 | 35 | 0.9 | Success | Bad | 6.7 | Good | -0.8 |
| Comparative Example 2 | 0.10 | 35 | 0.9 | Failure | Bad | 2.7 | Bad | -1.2 |
| Comparative Example 3 | 0.11 | 35 | 0.9 | Failure | Bad | 4.0 | Bad | -1.3 |

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Industrial Applicability

The carbon electrode is used for an electrochemical measurement system.

### Description of Reference Numerals

- 1: carbon electrode
- 2: substrate
- 3: conductive carbon layer
- 4: electrochemical measurement system

## Claims

1. An electrode comprising:
a substrate; and
a conductive carbon layer disposed at one side in a thickness direction of the substrate and having an sp² bond and an sp³ bond, wherein
a concentration ratio of oxygen to carbon is 0.07 or less on a one-side surface in a thickness direction of the conductive carbon layer.

2. The electrode according to Claim 1, wherein
the conductive carbon layer has a thickness of 5 nm or more and 200 nm or less.

3. The electrode according to Claim 1 or 2, wherein
the one-side surface in the thickness direction of the conductive carbon layer has a surface roughness Ra of 1.0 nm or less.

4. The electrode according to Claim 1, being an electrode for an electrochemical measurement.

5. The electrode according to Claim 4, being a working electrode, wherein the electrochemical measurement is anodic stripping voltammetry.

6. An electrochemical measurement system comprising the electrode according to Claim 4.
